(19) Europäisches Patentamt
European Patent Office
Office européen des brevets

(11) **EP 0 855 662 B1**

(12) **EUROPÄISCHE PATENTSCHRIFT**

(45) Veröffentlichungstag und Bekanntmachung des Hinweises auf die Patenterteilung:
**25.05.2011 Patentblatt 2011/21**

(51) Int Cl.:
***G06F 17/50*** *(2006.01)*

(21) Anmeldenummer: **98101077.0**

(22) Anmeldetag: **22.01.1998**

(54) **Elektrische Analyse integrierter Schaltungen**

Electrical analysis of integrated circuits

Analyse électrique des circuits integrés

(84) Benannte Vertragsstaaten:
**DE FR GB IT**

(30) Priorität: **24.01.1997 DE 19702600**

(43) Veröffentlichungstag der Anmeldung:
**29.07.1998 Patentblatt 1998/31**

(73) Patentinhaber: **SGS-THOMSON MICROELECTRONICS GMBH**
**85630 Grasbrunn (DE)**

(72) Erfinder: **Bonitz, Rainer**
**83043 Bad Aibling (DE)**

(74) Vertreter: **Hirsch, Peter**
**Klunker Schmitt-Nilson Hirsch**
**Patentanwälte**
**Destouchesstrasse 68**
**80796 München (DE)**

(56) Entgegenhaltungen:
**EP-A- 0 481 117    EP-A- 0 556 900**

- **P. BECQUE: "Getrennt spezifizieren, vereint simulieren" ELEKTONIK, Bd. 44, Nr. 20, 6.Oktober 1995, POING, DE, Seiten 102-108, XP000535709**
- **T. J. THATCHER ET AL: "Automatic Partitioning and Dynamic Mixed-Mode Simulation" IEEE 1992 CUSTOM INTEGRATED CIRCUITS CONFERENCE, 3. - 6.Mai 1992, BOSTON, MA, US, Seiten 12.7.1-12.7.4, XP000340900**

**EP 0 855 662 B1**

**Beschreibung**

Die Erfindung betrifft ein Verfahren zur Analyse des elektrischen Verhaltens monolitisch integrierter Schaltungen, welches zur Verbesserung des elektromagnetischen Emissionsverhaltens integrierter Schaltungen eingesetzt werden kann.

Moderne monolitisch integrierte Halbleiterschaltungen mit sehr hohem Integrationsgrad sind meist so komplex, daß man sich sowohl bei ihrem Entwurf als auch bei der Analyse ihres elektrischen Verhaltens und teilweise auch bei ihrer Optiminierung Computerprogrammen bedient. Beispielsweise gibt es Computerprogramme, mittels welchen elektrische Schaltbilder oder Funktionsblockschaltbilder in Layout-Information umsetzbar sind, mittels welcher Layouts für integrierte Halbleiterschaltungen erstellbar sind. Andererseits gibt es Computerprogramme, mittels welchen aus Schaltbildern oder Layouts von integrierten Schaltungen Simulationscomputermodelle erstellbar sind, anhand welcher das Verhalten und/oder die Reaktion der per Computermodell simulierten integrierten Schaltungen oder Teile davon ermittelt oder getestet werden können.

Beispielsweise kann man mit einem Computerprogramm namens AMPS (Automatic Minimization of Power through Sizing) digitale CMOS-Schaltungen hinsichtlich Leistung, Arbeitsgeschwindigkeit und Platzbedarf auf dem Chip optimieren. Dieses Programm ist dazu in der Lage, Transistoren automatisch umzudimensionieren, nämlich größer und/oder kleiner zu machen, um eine Kombination aufzufinden, welche den benutzerdefinierten Zielen hinsichtlich Leistung, Geschwindigkeit und Chipplatzbedarf am nächsten kommt, ohne die Funktionalität des Entwurfs der integrierten Schaltung zu ändern. Dieses Computerprogramm eignet sich einerseits zum Entwurf von Zellen integrierter Schaltungen und kann andererseits nach Beendigung des Entwurfs der integrierten Schaltung zur Überprüfung verwendet werden, ob die angestrebten Ziele erreicht worden sind oder ob weitere Verbesserungen erforderlich sind. Hinweise auf dieses Computerprogramm findet man im Handbuch .........EPIC 3.3.1 Release Notes, Seite 2-3.

Ein Problem mit zunehmender Bedeutung besteht bei integrierten Halbleiterschaltungen darin, daß durch elektromagnetische Emission hochfrequenter Störstrahlung über Versorgungs- und Funktions-Anschlußpins eines Halbleiterbausteins bei bestimmten Anwendungen andere integrierte Halbleiterschaltungen in ihrer Funktion gestört werden können oder daß der betrachtete Halbleiterbaustein einer Einstrahlempfindlichkeit hinsichtlich solcher hochfrequenter Störstrahlung unterliegt. Es besteht daher das Bestreben, die Güte einer integrierten Schaltung hinsichtlich Abstrahlungsverhalten und/oder Einstrahlempfindlichkeit bezüglich hochfrequenter elektromagnetischer Emission bereits während der Schaltungsentwicklung zu überprüfen und zu optimieren.

In der Veröffentlichung "Analog System Engineering" von Michael Gutzmannn, Seiten 8 und 9, ist unter dem Abschnitt "Simultaneous switching noise of CMOS Systems" eine Methode zur Erstellung eines Simulationsmodells und zur Durchführung einer Simulation beschrieben, bei welcher beispielsweise das Schaltungssimulationsprogramm SPICE verwendet werden kann. Dabei werden zunächst durch Erstellung einer R, L, C, G-Matrix elektrische Parameter entweder einer gesamten integrierten Schaltung oder nur einer Zelle hiervon extrahiert, werden einerseits ein elektrisches Netzwerk des Gehäuses mit den Anschlußbeinen und den Anschlußzuleitungen und ein Modell der E/A-Schaltungen (EINGANGS/ AUSGANGS-Schaltungen) erstellt und wird auf deren Grundlage eine Schaltungssimulation beispielsweise mit dem Programm SPICE durchgeführt. Die Schaltungssimulation liefert sogenannte Übergangswellenformen in Form einer zeitlichen Aufzeichnung der Stromverläufe an allen interessierenden Schaltungsknoten der integrierten Schaltung bzw. der Zelle.

Verwendet man diese bekannte Methode zur Modellerstellung und Simulation einer gesamten integrierten Schaltung, kann man nur ein relativ grobes Modell erstellen. Denn hochintegrierte Schaltungen heutiger Art sind so komplex, daß man dann, wenn man zu guten Simulationsergebnissen für die gesamte integrierte Schaltung kommen möchte, was ein relativ feines Simulationsmodell und eine ausreichend hohe Auflösung durch Verwendung einer entsprechend hohen Abtastrate der durch Simulation erhaltenen Signalverläufe erfordert, auch bei Verwendung schneller Rechner zu Rechenzeiten käme, die für die Praxis bei weitem zu lang wären. Man müßte mit Rechenzeiten von etwa 2 bis 3 Monaten rechnen.

Um zu praktisch noch akzeptierbaren Rechenzeiten zu kommen, müßte man für die Durchführung der Simulation ein sehr vereinfachtes oder grobes Simulationsmodell und/oder eine sehr schlechte Auflösung durch niedrige Abtastraten verwenden. Beides reduziert zwar die erforderliche Rechenzeit, führt jedoch nur zu recht ungenauen Ergebnissen, die häufig nicht akzeptierbar sind.

Eine andere Möglichkeit besteht darin, ein Simulationsmodell nicht von der gesamten integrierten Schaltung zu erstellen sondern nur von einer Zelle, das heißt, einem ausschnittsweisen Funktionsblock, der integrierten Schaltung zu erstellen. Hierdurch kann man zwar auch mit feineren Simulationsmodellen und mit höherer Auflösung durch Verwendung höherer Abtastraten zu erträglicher Rechenzeit kommen. Das Simulationsergebnis ist aber wiederum zu ungenau, weil die gesamte Umgebung der simulierten Zelle, nämlich der Rest der integrierten Schaltung, Gehäuseparameter, E/A-Strukturen, Zuleitungsstrukturen, Versorgungsspannungsstrukturen usw. gänzlich unberücksichtigt bleiben, obwohl sie auf die Funktion der simulierten Zelle der integrierten Schaltung einen beträchtlichen Einfluß haben können.

In EP 0 481 117 A1 ist ein Verfahren zur Beschleunigung der Simulation beim rechnergestützten Entwurf elektronischer Schaltungen und Systeme beschrieben, insbesondere ein gesteuertes Verfahren zur mixed mode Simulation elektronischer Schaltungen und Systeme. Dabei ermöglicht die Verwendung eines speziellen waveform relaxation Algorithmus die gleichzeitige ereignisgesteuerte Simulation digitaler und analoger Schaltungsteile auf unterschiedlichen Schaltungs-/Beschreibungsebenen. Es werden jeweils nur die Elementfunktionen derjenigen Elemente berechnet, die für den jeweils betrachteten Zeitpunkt relevant sind, d.h., an deren Eingängen eine Änderung des Eingangssignals vorliegt. Bei der mixed mode Simulation arbeitet der Simulator auf allen Ebenen gleichzeitig. Es werden nebeneinander gleichzeitig mehrere Bibliotheken für die verschiedenen Schaltungs-/Beschreibungs- und Simulationsebenen verwendet. Die zu simulierende Gesamtschaltung wird auf allen Simulationsebenen gleichzeitig simuliert.

In P. BECQUE: "Getrennt spezifizieren, vereint simulieren", Elektronik, Bd. 44, Nr. 20, 6. Oktober 1995, Seiten 102-108 ist ebenfalls auf ein Simulationsmodell unter Berücksichtigung einer gemischt analog/digitalen Interaktion Bezug genommen, um ein System unter realistischen Betriebsbedingungen zu analysieren.

In EP 0 556 900 A2 wird auf eine Extraktion von verschiedenen Parametern aus einer Abstraktionsebene in eine andere Abstraktionsebene Bezug genommen für eine Simulation eines elektronischen Systems. Es wird hierbei von jedem Funktionsblock ein Abstraktionsmodell in einer höheren Ebene und ein Abstraktionsmodell in einer niedrigeren Ebene erstellt.

In T.J. Thatcher et al; "Automatic partitioning and dynamic mixed-mode simulation", IEEE, 1992, Custom integrated circuits conference, 3. Mai 1992 - 6. Mai 1992, Seiten 12.7.1-12.7.4 ist ein Simulationsverfahren beschrieben, bei dem es darum geht, von Schaltungsteilen jeweils zwei Modelle zu erzeugen, wobei es dem Simulationsprogramm überlassen ist, jeweils zu entscheiden, auf das entpsrechende Modell umzuschalten.

In R. BEALE et al: "Design methodology and simulation tools for mixed analog-digital integrated circuits", IEEE International systems on circuits and systems, Seiten 1351-1355. Mai 1990 ist ein Simulationsverfahren beschrieben, bei dem eine Simulation eines Systems durchgeführt werden kann, wobei einige funktionale Blöcke durch eine feine Beschreibung dargestellt sind und andere funktionale Blöcke durch eine grobere Beschreibung, die aus einer feineren Beschreibung abstrahiert wurde.

Mit der vorliegenden Erfindung sollen solche Probleme überwunden werden. Insbesondere sollen mit praktisch akzeptierbaren Rechenzeiten Simulationen ermöglicht werden, die eine genügend hochwertige Aussage über das Funktionsverhalten, insbesondere im Zusammenhang mit elektromagnetischer Störemission, interessierender Zellen von integrierten Schaltungen ermöglichen.

Zu diesem Zweck macht die Erfindung ein Verfahren verfügbar, wie es in Anspruch 1 angegeben ist und das den abhängigen Ansprüchen entsprechend weitergebildet werden kann.

Die Kernidee der Erfindung liegt darin, für die Simulation ein Mischmodell zu verwenden, das zusammengesetzt ist aus einem Feinmodellteil hinsichtlich der interessierenden Zelle und einem Grobmodellteil hinsichtlich des Restes der integrierten Schaltung, wobei man dem Grobmodellteil vorzugsweise auch ein Zuleitungsmodell und/oder ein Spannungsversorgungsmodell und/oder ein Eingangs/Ausgangsstrukturmodell und/oder ein Gehäusestrukturmodell und/oder ein Lastmodell hinzufügen kann. Zur Erstellung des Grobmodellteils werden nur passive Bauelemente in Form von komplexen Widerständen berücksichtigt, während für die Erstellung des Feinmodellteils aktive Bauelemente, passive Bauelemente und parasitäre Komponenten berücksichtigt werden.

Das resultierende Fein-Grob-Computermodell weist einerseits eine ausreichend geringe Komplexität auf, um damit eine Simulation mit hoher Auflösungsgenauigkeit und trotzdem für praktische Zwecke genügend kurzer Rechenzeit durchführen zu können, und berücksichtigt andererseits anhand des Grobmodellteils genügend die sich auf das elektrische Verhalten der Zelle auswirkende elektrische Umgebung dieser Zelle.

Für die Modellerstellung und für die Simulation können bekannte Computerprogramme verwendet werden, beispielsweise das Programm DRACULA für die Extraction und das seit langem bewährte Programm SPICE für die Simulation.

Bei herkömmlichen Simulationsverfahren werden üblicherweise digitale Stimulationssignale verwendet in Form von Stimulationsimpulsen mit abgeschrägten Impulsflanken. Solche Stimulationssignale sind aber häufig von der Form wirklich auftretender Signale so weit entfernt, daß sie der Erzielung guter Simulationsergebnisse entgegenstehen.

Bei einer besonders bevorzugten Ausführungsform des erfindungsgemäßen Verfahrens werden daher vor der Durchführung der eigentlichen Feinsimulation mittels des Fein-Grob-Computermodells realistischere Stimulationssignale verfügbar gemacht, indem zunächst von der gesamten integrierten Schaltung ein nur deren aktive Bauelemente berücksichtigendes Grobsimulationscomputermodell erzeugt und mit dessen Hilfe eine Grobsimulation durchgeführt wird, indem die vorbestimmten Betriebsparameter vorgegeben und Eingangsanschlüsse des Grobsimulationscomputermodells mit Testsignalen vorbestimmter Signalform beaufschlagt und dabei an Ein- und/oder Ausgangsanschlüssen der interessierenden Zelle des Grobsimulationscomputermodells entstehende analoge Antwortsignale als Stimulationssignale aufgezeichnet und gespeichert werden, die dann als Stimulationssignale bei der Feinsimulation verwendet werden. Zur Extraktion des Grobsimulationscomputermodells kann man z.B. das Programm DRACULA verwenden und für die Grobsimulation einen Mixed Mode Simulator, beispielsweise das Programm ELDO oder das Programm EPIC.

Das erfindungsgemäße Verfahren läßt sich vorteilhafterweise zur Verbesserung des elektromagnetischen Emissionsverhaltens der interessierenden Zelle der integrierten Schaltung verwenden, wobei mittels einer programmgesteuerten Iterationsroutine und unter Beachtung vorbestimmter Funktionsgrenzen der Zelle eine gezielte Änderung des Feinmodells der Zelle durchgeführt wird, die Feinsimulation und deren Bewertung wiederholt werden und die Iteration mit erneuten Änderungen des Feinmodells, welche in Betracht ziehen, ob die vorausgehende Änderung zu einem besseren oder schlechteren Ergebnis geführt hat, so lange wiederholt wird, bis sich hinsichtlich des elektromagnetischen Emissionsverhaltens der Zelle nur noch Änderungen unterhalb eines vorbestimmten Schwellenwertes ergeben.

Bei der Feinsimulation und gegebenenfalls auch bei der Grobsimulation kann man für die Betriebsparameter entweder typische Werte vorgeben oder "worst case" - Werte, also die im schlechtesten Betriebsfall zu erwartenden Werte. Man kann aber auch die Simulationen sowohl mit typischen Werten als auch mit worst case-Werten durchführen.

Bei der Aufzeichnung der bei der Simulation entstehenden Signalverläufe sollte eine Abtastfrequenz verwendet werden, die mindestens so hoch ist wie sie vom Abtasttheorem vorgeschrieben ist, also mindestens zwei mal so hoch wie die höchste im Signalverlauf auftretende Frequenz. Bevorzugt wird jedoch eine wesentlich höhere Auflösung, beispielsweise mit einer Abtastfrequenz, die fünf mal so hoch ist wie die vom Abtasttheorem geforderte Abtastfrequenz. Sind beispielsweise Signalverläufe mit einem Frequenzbereich von 0 bis 1 GHz abzutasten, wird eine Abtastrate mit einem zeitlichen Abstand benachbarter Abtastimpulse von beispielsweise 0,2 ns bevorzugt.

Bei periodischen Signalverläufen wird vorzugsweise eine Fourier-Transformation durchgeführt, um das Frequenzspektrum des jeweiligen Signalverlaufs zu erstellen. Bei einmaligen Vorgängen kann die Spektralanalyse auch durch andere Spektralanalysemethoden erfolgen, beispielsweise durch eine Z-Transformation (numerische Methoden). Bei Signalverläufen, die einmalige Vorgänge darstellen, kann man aber auch eine periodische Wiederholung der Stimulation des Simulationsmodells durchführen, um zu periodischen Signalverläufen zu kommen, die dann wieder der Fourier-Transformation unterzogen werden können.

Bei üblichen Extraktionsverfahren zur Erstellung eines Computermodells mittels der Layout-Extraktion werden zwischen zwei Schaltungsknoten des Simulationsmodells nur beispielsweise ein Widerstand und eine Knotenkapazität ermittelt. Dabei wird die Knotenkapazität einem der beiden Schaltungsknoten zugeordnet, der Widerstand dagegen dem anderen Schaltungsknoten. Stellt die elektrische Strecke zwischen den beiden Schaltungsknoten eine bidirektionale Verbindung dar, führt diese einseitige Zuordnung von Widerstand und Knotenkapazität zu dem einen bzw. dem anderen Schaltungsknoten zu Verfälschungen der Stimulationsergebnisse. Aus diesem Grund erfolgt bei einer bevorzugten Ausführungsform des erfindungsgemäßen Verfahrens während der Layout-Extraktion als zusätzlicher Schritt eine Ersatznetzwerkbildung (z.B. mit dem Programm DIVA), bei welcher beispielsweise Widerstände und Kapazitäten entsprechend bekannten Leitungsersatzschaltbildern in einer Anzahl von seriellen Widerständen und Querkapazitäten verteilt sind. Dies kommt der physikalischen Wirklichkeit wesentlich näher und führt daher zu wesentlich besseren Simulationsergebnissen.

Bei der Simulation von Ausgangsstufen einer integrierten Schaltung wird deren Simulationsmodell vorzugsweise nicht mit Leerlauf am Ausgang simuliert sondern unter Berücksichtigung der typisch zu erwartenden externen Last.

Die Erfindung wird nun anhand von Ausführungsformen näher erläutert. In den Zeichnungen zeigen:

Fig. 1    ein Blockschaltbild eines Fein-Grob-Computermodells, wie es bei einem erfindungsgemäßen Simulationsverfahren verwendbar ist;

Fig. 2    ein elektrisches Schaltbild eines herkömmlichen CMOS- Inverters;

Fig. 3    ein Beispiel eines Chip-Layouts des in Fig. 2 gezeigten Inverters;

Fig. 4    ein aus dem Chip-Layout gemäß Fig. 3 extrahiertes Simulationsmodell des Inverters;

Fig. 5    Beispiele von Hüllkurven als Frequenzspektrumbewertungs- schablonen;

Fig. 6-13    durch erfindungsgemäße Simulation erhaltene Signalverläufe vor bzw. nach iterativer Optimierung hinsichtlich des elektro- magnetischen Emissionsverhaltens, wobei diese Figuren speziell zeigen:

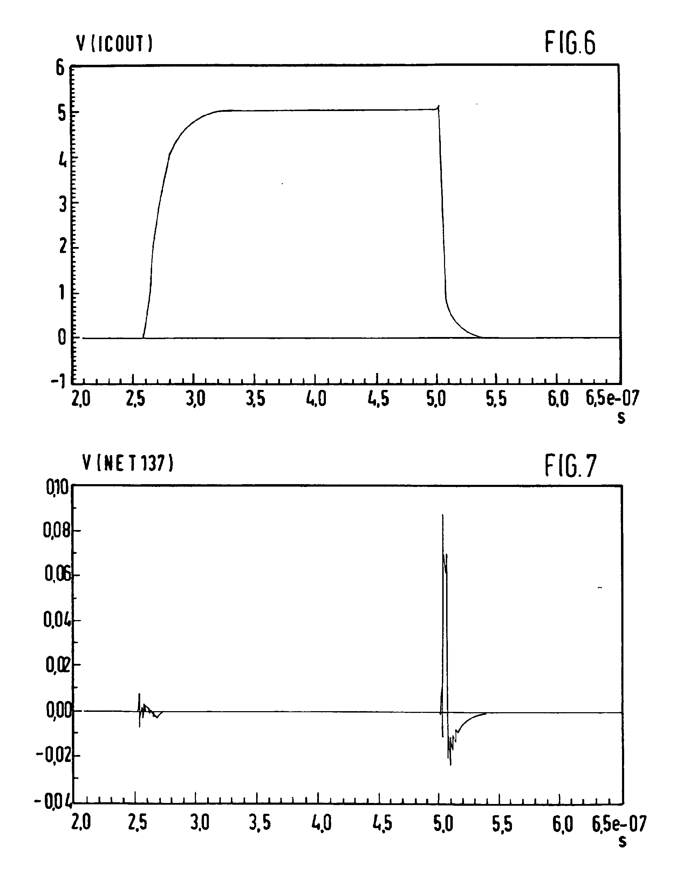

Fig. 6    einen Signalverlauf am Ausgangsanschlußstift eines Ausgangs- treibers einer integrierten Schaltung ohne Optimierung;

Fig. 7    einen Signalverlauf an einer internen Versorgungsspannungs- leitung der integrierten Schaltung ohne Optimierung;

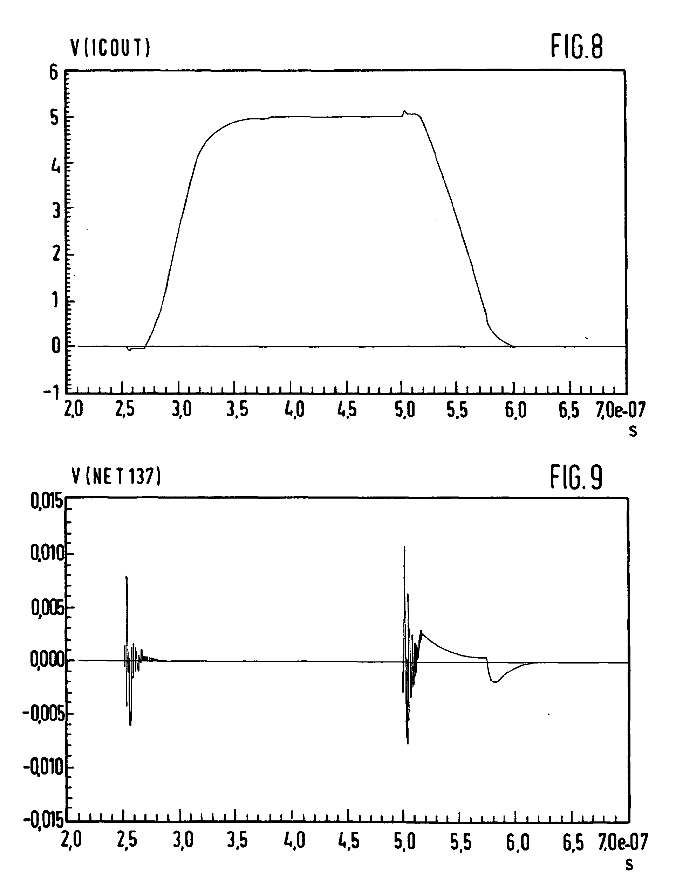

Fig. 8    einen Signalverlauf am Ausgangsanschlußstift nach iterativer Optimierung;

Fig. 9    einen Signalverlauf an einer internen Masseleitung der integrier- ten Schaltung nach iterativer Optimierung;

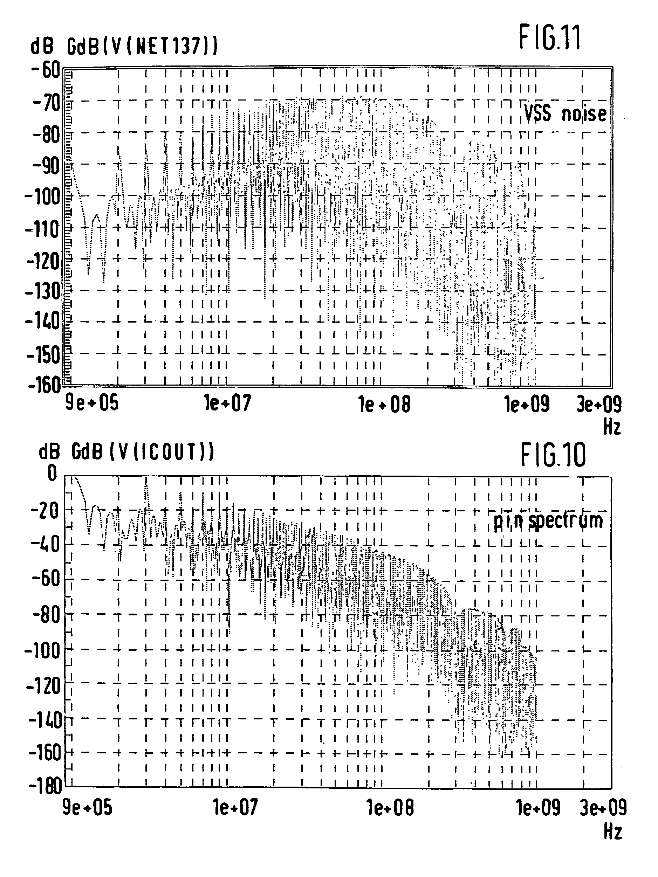

Fig. 10    ein Frequenzspektrum eines Signalverlaufs an dem Ausgangs- anschlußstift ohne Optimierung;

Fig. 11    ein Frequenzspektrum eines Signalverlaufs an der internen Spannungsversorgungsleitung ohne Optimierung;

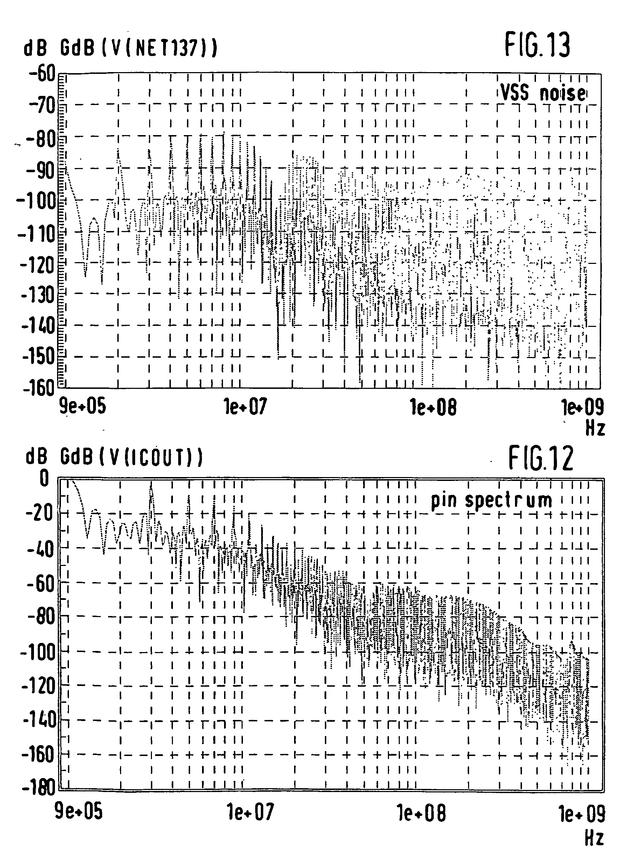

Fig. 12    ein Frequenzspektrum eines Signalverlaufs an dem Ausgangs- anschlußstift nach einer iterativen Optimierung; und

Fig. 13    das Frequenzspektrum eines Signalverlaufs an der internen Spannungsversorgungsleitung nach iterativer Optimierung.

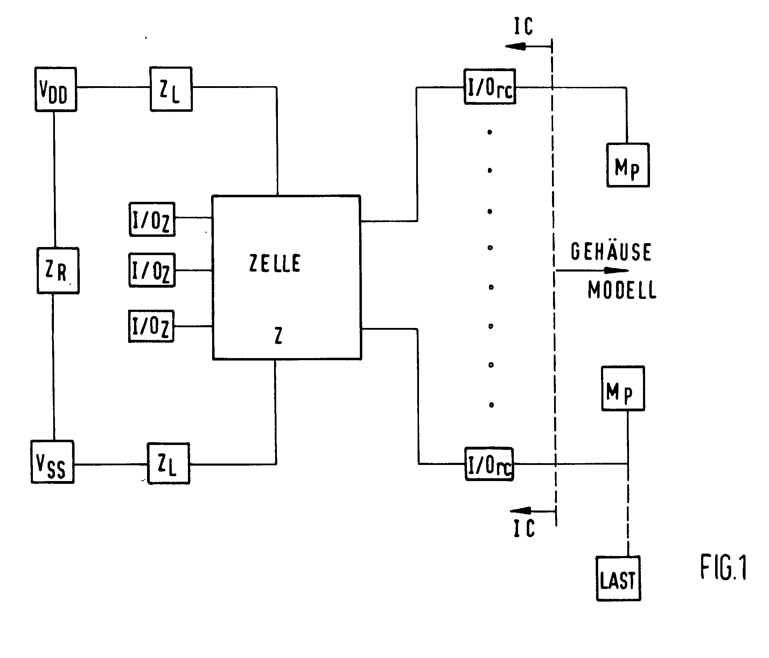

Fig. 1 zeigt ein Beispiel eines Fein-Grob-Computer- oder -Simulationsmodells zur Durchführung eines erfindungsgemäßen Simulationsverfahrens. Dargestellt ist das Fein-Grob-Simulationsmodell einer integrierten Schaltung, das ein Feinmodell einer hinsichtlich ihres elektrischen Verhaltens interessierenden Zelle Z mit internen Eingängen/ Ausgängen $I/O_Z$ und ein Grobmodell von folgenden Komponenten enthält:

- ein Grobmodell $Z_R$ vom Rest des Chips der integrierten Schaltung IC;
- ein Grobmodell $V_{DD}$ und $V_{SS}$ als Spannungsversorgungsmodell,
- ein Grobmodell $Z_L$ als die Zuleitungen zur Zelle Z berücksichtigendes Zuleitungsmodell,
- $I/O_{IC}$ als Eingangs/Ausgangs-Strukturmodell, welches die externen Eingangs/Ausgangs-Anschlüsse der integrierten Schaltung IC berücksichtigt,
- ein Grobmodell $M_P$ als Gehäusemodell zur Berücksichtigung der elektrischen Parameter des Gehäuses und der Gehäuseleitungen der integrierten Schaltung und
- ein Grobmodell LAST, welches die externe Last der integrierten Schaltung repräsentiert.

Bei einer bevorzugten Ausführungsform des erfindungsgemäßen Verfahrens wird folgendermaßen vorgegangen:

1. Zunächst wird von der gesamten integrierten Schaltung ein Grobsimulationscomputermodell erzeugt, das nur deren aktive Komponenten, wie Dioden und Transistoren, berücksichtigt. Hierzu kann ein herkömmliches Computerprogramm verwendet werden, beispielsweise das bereits erwähnte Programm DRACULA, mittels welchem in Form einer Schaltungslayoutextraktion eine Netzlistenbeschreibung erzeugt wird, welche nur die aktiven Komponenten der integrierten Schaltung berücksichtigt. Anhand dieses Grobsimulationscomputermodells wird dann eine Grobsimulation durchgeführt. Dabei werden bestimmte Betriebsparameter vorgegeben wie insbesondere die Betriebstemperatur und die Versorgungsspannung, sowie Parameter des verwendeten Extraktionsprogramms und des verwendeten Simulationsprogramms. Die Eingangsanschlüsse des Grobsimulationscomputermodells werden dann mit Testsignalen vorbestimmter Signalform beaufschlagt. Diese rufen an interessierenden Ein- und/oder Ausgangsanschlüssen des Grobsimulationscomputermodells analoge Antwortsignale hervor, die als Stimulationssignale für die spätere Feinsimulation aufgezeichnet und gespeichert werden. Diese Stimulationssignale berücksichtigen schon grob das elektrische Verhalten der integrierten Schaltung und sind daher für eine nachfolgende Feinsimulation wesentlich besser geeignet und führen zu wesentlich besseren Simulationsergebnissen als wenn man die Feinsimulation mit der Beaufschlagung mit Testsignalen beginnen würde, ohne die Grobsimulation vorauszuschicken.

2. Als nächstes wird dann ein Fein-Grob-Computer- oder Simulationsmodell erstellt. Hierzu beginnt man beispielsweise mit der Erstellung des Feinmodells der interessierenden Zelle Z. Hierbei kann man sich wieder eines herkömmlichen Computerprogramms bedienen, das mit Hilfe einer Schaltungslayoutextraktion eine Netzlistenbeschreibung erzeugt. Diese enthält für den Zweck der Erstellung des Feinmodells jedoch nicht nur die aktiven Komponenten (beispielsweise Transistoren und Dioden) der Zelle Z sondern auch deren passive Komponenten (Widerstände, Kapazitäten, Induktivitäten) und alle parasitären Elemente (dargestellt ebenfalls in Form von Widerständen, Kapazitäten und Induktivitäten), welche durch die Geometrien auf dem Halbleiterchip der integrierten Schaltung bedingt sind. Damit ist der in Fig. 1 als Zelle Z bezeichnete Teil des Fein-Grob-Simulationsmodells erstellt.

3. Zur Vervollständigung des Fein-Grob-Simulationsmodells werden nun noch die Grobmodelle $Z_R$, $Z_L$, $V_{DD}$, $V_{SS}$, $I/O_{IC}$, $M_P$ und LAST erstellt. Auch hierfür kann man wieder das herkömmliche Computerprogramm zur Netzlistenbeschreibung mit Hilfe einer Schaltungslayoutextraktion verwenden, wobei allerdings nur passive Schaltungskomponenten in Form von komplexen Widerständen berücksichtigt werden.

Die Auswahl, ob nur aktive Komponenten, nur passive Komponenten oder sämtliche Komponenten einschließlich parasitärer Elemente in eine Netzlistenbeschreibung für ein Simulationsmodell aufgenommen werden sollen, kann man beispielsweise durch Filter bewirken, welche bei der jeweiligen Schaltungslayoutextraktion nur die jeweils gewünschten Komponenten in die Netzliste lassen.

Bei der Gehäuseanalyse zur Erstellung des Gehäuse-Grobmodells wird vorzugsweise von dem Gehäuse der integrierten Schaltung ein Ersatzschaltbild in Form eines RLC-Netzwerkes erstellt, wobei die Werte der einzelnen Ersatzschaltbildkomponenten auf Messungen basieren. Es wird ein Modell für jeden Anschlußpin des Gehäuses erstellt.

4. Nach Erstellung eines der Fig. 1 entsprechenden Fein-Grob-Simulationsmodells wird dann anhand dieses Modells eine Feinsimulation durchgeführt. Dabei werden beispielsweise die gleichen Betriebsparameter wie bei der vorausgehenden Grobsimulation vorgegeben und werden als Stimulationssignale die bei der Grobsimulation aufgezeichneten und gespeicherten Antwortsignale des Grobsimulationscomputermodells verwendet. Hierbei werden möglichst viele Teile des Fein-Grob-Simulationsmodells durch Stimulation aktiviert, um die simulierte Zelle Z in alle möglichen elektrischen Zustände zu versetzen. Dadurch werden sowohl Einschwingvorgänge berücksichtigt als auch Vorgänge und Reaktionen, die erst im eingeschwungenen Zustand auftreten.

5. An den interessierenden Stellen des Fein-Grob-Simulationsmodells werden die durch die Stimulationen hervorgerufenen Signalverläufe abgetastet und aufgezeichnet. Vorzugsweise findet die Aufzeichnung solcher Signalverläufe statt, die an die integrierte Schaltung IC verlassenden Schaltungsknoten entstehen, das heißt, an den letzten Schaltungsknoten, bevor es in die externe Umwelt des Chips der integrierten Schaltung geht. Die Aufzeichnung dieser Signalverläufe erfolgt mit möglichst hoher Abtastrate, die vorzugsweise fünf mal so hoch wie die vom Abtasttheorem geforderte Abtastrate ist, um eine hohe Auflösung und damit gute Simulationsergebnisse zu erhalten.

6. Anschließend wird eine Spektralanalyse der aufgezeichneten und gespeicherten Signalverläufe des Fein-Grob-Simulationsmodells durchgeführt, vorzugsweise mit Hilfe einer Fourier-Transformation, mit deren Hilfe ein Frequenzspektrum der abgetasteten und aufgezeichneten Signalverläufe erstellt wird. Hierbei kann man sich eines "Waveform postprocessor" bedienen, beispielsweise des Programms XELGA. Hierbei sollten die für eine Spektralanalyse wichtigen Parameter, wie Abtastfrequenz und Anzahl der Abtastungen, beachtet werden.

Die Darstellung im Frequenzbereich erfolgt vorzugsweise in doppellogarithmischer Skalierung, wobei der Betrag und die Phase der komplexen Amplitude dargestellt werden.

7. Die Auswertung des Simulationsergebnisses erfolgt durch eine Bewertung der Störamplituden in der Frequenzspektrumdarstellung des jeweiligen Signalverlaufs, wobei die Höhe der Störamplitude ein Maß für die Güte des jeweiligen Schaltungsknotens bezüglich einer möglichen HF-Abstrahlung darstellt. Die Auswertung und Bewertung erfolgt dabei beispielsweise entsprechend bekannter VDE-Richtlinien oder bekannter SAE-Normen der USA.

8. Durch gezieltes Abändern der zu untersuchenden Schaltung und erneutes Durchführen der Schritte 1. bis 7. kann eine Verbesserung des Störemissionsverhaltens der Zelle erreicht werden.

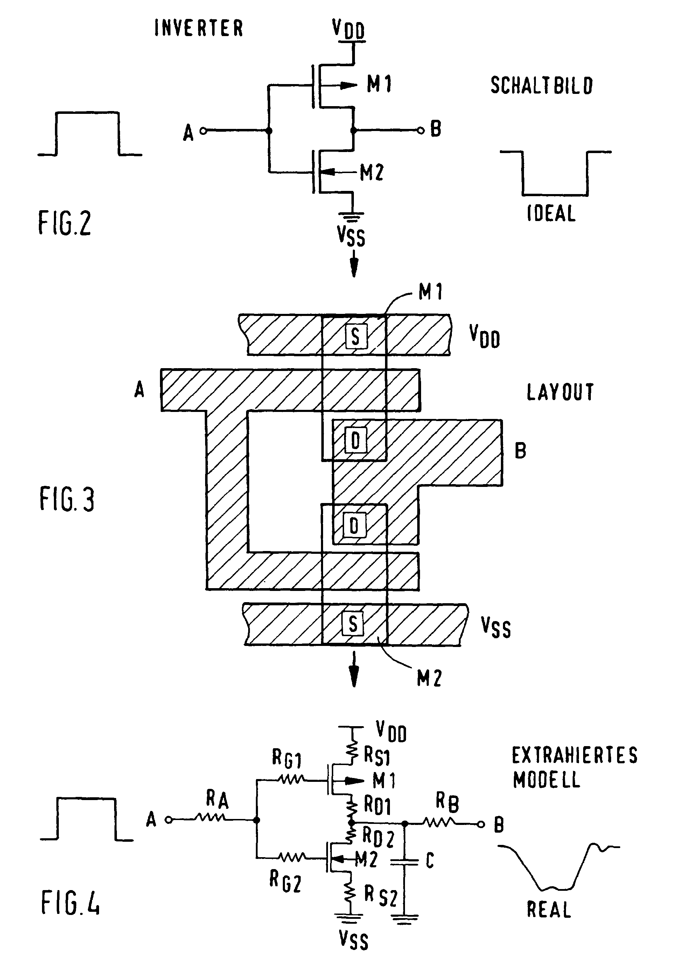

Anhand der Fig. 2 bis 4 wird an dem einfachen Beispiels eines CMOS-Inverters eine Modellextrahierung erläutert.

Ein CMOS-Inverter der in Fig. 2 dargestellten Art enthält zwei in Reihe geschaltete MOS-Transistoren M1 und M2 entgegengesetzten Kanaltyps, die zwischen die beiden Versorgungsspannungsanschlüsse $V_{DD}$ und $V_{SS}$ einer Spannungsversorgungsquelle geschaltet sind. Die Gate-Anschlüsse der beiden Transistoren M1 und M2 sind gemeinsam mit einem Eingangsanschluß A verbunden und deren Drainanschlüsse sind gemeinsam mit einem Ausgangsanschluß B verbunden. Ein dem Eingangsanschluß A zugeführter Rechteckimpuls hat am Ausgangsanschluß B einen invertierten Ausgangsimpuls zur Folge, wobei in Fig. 2 ideale Impulse und ideale Übertragungseigenschaften des Inverters angenommen sind.

Fig. 3 zeigt ein mögliches Layout eines Inverters der in Fig. 2 gezeigten Art. Mit dicker Umrahmung sind die MOS-Transistoren M1 und M2 dargestellt. Leiterbahnen für die Spannungsversorgung einerseits und für die Verbindung der Gatezonen und der Drainzonen der beiden Transistoren M1 und M2 mit dem Eingangsanschluß A bzw. dem Ausgangsanschluß B sind schraffiert dargestellt.

Fig. 4 zeigt ein einfaches extrahiertes Modell eines Inverters mit dem in Fig. 3 gezeigten Layout. Dabei sind neben den aktiven Komponenten M1 und M2 nur Widerstände und eine Kapazität in das extrahierte Modell aufgenommen worden. Ein genaueres Modell könnte weitere Kapazitäten und zusätzlich Induktivitäten enthalten, möglicherweise auch parasitäre Komponenten der Transistoren M1 und M2. Eine weitere Verfeinerung könnte darun bestehen, die passiven Elemente entsprechend der Leitungstheorie aufzuteilen (z.B. mit dem Programm DIVA).

In dem extrahierten Modell in Fig. 4 sind im wesentlichen die durch die metallischen Leiterbahnen gebildeten Leitungswiderstände berücksichtigt, nämlich Sourcezuleitungswiderstände $R_{S1}$, und $R_{S2}$, die Drainzuleitungswiderstände $R_{D1}$, und $R_{D2}$, die Gatezuleitungswiderstände $R_{G1}$ und $R_{G2}$ sowie die Leitungswiderstände $R_A$ und $R_B$ der Verbindungsleitungen mit den Anschlüssen A und B. Außerdem ist eine zwischen dem gemeinsamen Drainanschluß und der Masseleitung ($V_{SS}$) vorhandene Kapazität C dargestellt.

Aufgrund der Berücksichtigung derartiger Widerstände und Kapazitäten in dem extrahierten Modell führt bei diesem Modell die Simulation der Einspeisung eines idealen Rechteckimpulses am Eingangsanschluß A nicht zu einem entsprechend idealen invertierten Ausgangsimpuls am Ausgangsanschluß B sondern dort erscheint als Simulationsergebnis ein "realer" invertierter Impuls mit bestimmten Impulsschrägen und Einschwingbereichen.

Die Umsetzung einzelner in Schaltbilddarstellung vorliegender Bauelemente oder Bauelementegruppen von integrierten Schaltungen in entsprechende Chip-Layouts können heutzutage Computerprogramme automatisch durchführen. Dies gilt auch für das Erstellen oder Extrahieren eines Computermodells aus einem solchen Layout. Aus den Mustern und Dimensionen solcher Layouts kann das Computerprogramm die parasitären Komponenten, die neben den aktiven Elementen in Form der Transistoren M1 und M2 bestehen, ermitteln und in das extrahierte Modell mit einbringen.

Im praktischen Fall der Analyse oder Optimierung einer interessierenden Zelle einer integrierten Schaltung ist diese Zelle wesentlich komplexer als ein einfacher Inverter der in Fig. 2 gezeigten Art. Die programmgesteuerte Layout-Erstellung und/oder Modellextrahierung geschieht aber prinzipiell gleich.

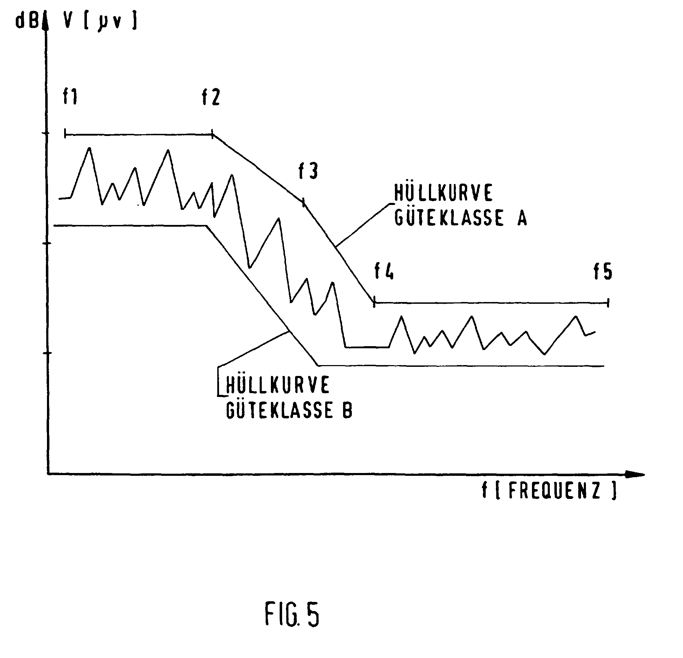

In Fig. 5 ist ein angenommenes Beispiel für ein Frequenzspektrum eines bei einer Feinsimulation erhaltenen Signalverlaufs dargestellt, zusammen mit Bewertungshüllkurven, welche die Funktion von Bewertungsschablonen haben. Dargestellt sind eine angenommene Hüllkurve einer Güteklasse A sowie eine angenommene Hüllkurve einer Güteklasse B. Je nach dem, welche Güteklasse man anwendet, wäre der Signalverlauf, dessen Frequenzspektrum in Fig. 5 dargestellt ist, akzeptabel oder nicht.

Die Fig. 6 bis 9 zeigen simulierte Signalverläufe an verschiedenen Stellen eines Simulationsmodells einer integrierten Schaltung vor bzw. nach einer Optimierung hinsichtlich elektromagnetischer Störemissionen mittels einer erfindungsgemäßen Simulationsmethode. Dabei zeigen die Fig. 6 und 8 ein simuliertes Ausgangssignal an einem Ausgangsanschluß eines Ausgangstreibers der simulierten integrierten Schaltung vor bzw. nach der Optimierung, während die Fig. 7 und 9 Signalverläufe an einer internen Spannungsversorgungsleitung (Masseleitung) des Simulationsmodells der integrierten Schaltung vor bzw. nach der Optimierung zeigen.

Ein Vergleich der Fig. 6 und 8 zeigt als hauptsächlichsten Effekt der Optimierung eine deutliche Verringerung der Steilheit sowohl der Anstiegsflanke als auch der Abfallflanke, was eine entsprechende Reduzierung der hohen Frequenzanteile in diesem Impulssignal und damit eine entsprechende Reduzierung der hochfrequenten Störemission bedeutet.

Ein Vergleich der Fig. 7 und 9 zeigt, daß die Amplitude des Störspannungssignals auf der internen Masseleitung von etwa 90 mV vor der Optimierung auf etwa 10 mV nach der Optimierung abgenommen hat, also nahezu um den Faktor 10.

In den Fig. 10 bis 13 sind Frequenzspektren der durch die Simulation erhaltenen Signalverläufe an dem Ausgangsanschluß des Modells der integrierten Schaltung bzw. auf einer internen Spannungsversorgungsleitung dargestellt.

Ein Vergleich der Fig. 10 und 12 zeigt eine Abnahme der oberen Hüllkurve im mittleren Frequenzbereich des Frequenzspektrums für den Ausgangsanschluß infolge der Optimierung um etwa 20 dB. Eine ähnliche Reduzierung der Störemission ergibt sich für das simulierte Signal auf der internen Spannungsversorgungsleitung, wie ein Vergleich der Fig. 11 und 13 zeigt.

Mit dem erfindungsgemäßen Verfahren ist somit eine automatische Optimierung von integrierten Schaltungen mit parameterorientierten Simulatoren möglich.

In abgeänderter Weise kann das Verfahren auch zur Ermittlung der Störfestigkeit integrierter Schaltungen gegen Störeinstrahlungen angewendet werden. Dabei können auf interne Spannungsversorgungsleitungen, einschließlich Masseleitungen, und/oder auf externe Anschlußpins des Simulationsmodells der integrierten Schaltung, welche für die Funktion der interessierenden Fälle bedeutend oder charakteristisch sein können, Stimulationssignale gegeben werden und kann die Erwartung mit dem Simulationsergebnis verglichen werden. Anhand des Frequenzspektrums aufgezeichneter Signalverläufe kann die Störfestigkeitsgüte der interessierenden Zelle bewertet werden. Hierfür kann man Stimulationssignale verwenden, deren Frequenzen gewobbelt sind und deren Leistungen und/oder Amplituden iterativ verschieden gemacht werden.

Vor einer Übertragung von Schaltungen oder Schaltungsteilen einer integrierten Schaltung in andere Halbleitertechnologien (einschließlich Dimensionsänderung bezüglich des Schaltungslayouts) kann deren Verhalten durch einfaches Austauschen der Simulationsmodelle vorhergesagt werden. Hierfür kann entweder eine neue Extraktion zur Erstellung eines neuen Simulationsmodells durchgeführt werden oder man kann eine Bewertung mit einem an die neuen Halbleitertechnologien angepaßten Simulationsmodell durchführen.

Die Modularisierung in Zellen und die Verwendung eines Fein-GrobModells mit Berücksichtigung der elektrischen Umwelt der interessierenden Zelle erlaubt gute Simulationsergebnisse bei Anwendbarkeit des Verfahrens auch bei begrenzter Rechnerleistung.

Neben der Möglichkeit, mit dem erfindungsgemäßen Verfahren eine interessierende Zelle zu verbessern, kann mit dem erfindungsgemäßen Verfahren auch der Einfluß verschiedenster Parameter auf das Störabstrahlverhalten untersucht werden. Solche Parameter sind beispielsweise Gehäuseparameter, Eingangs/Ausgangs-Strukturen, R, L, C-Netzwerke auf dem Chip, Versorgungsnetze, Taktfrequenzen und Taktstrategien, beispielsweise hinsichtlich der Form der Taktimpulse, Technologieparameter u.s.w.

Es folgt nun noch eine Liste von Bezugsquellen für vorausgehend genannte Computerprogramme und für weitere für das erfindungsgemäße Verfahren geeignete Programme:

| SOFTWARE | ANWENDUNGSGEBIET | ANBIETER |
|---|---|---|
| SPICE | Analoge Schaltungssimulation | Cadence, Haar bei München |
| DRACULA | Layoutextraktion (Netzliste) Layoutverifikation | Cadence |
| DIVA | Layoutextraktion (Netzliste) Layoutverifikation | Cadence |
| ELDO | Mixed mode simulation | Mentor Graphics, München |
| EPIC (Amps, Timemill, Powermill, ...) | Mixed mode simulation Timing-Verifikation Schaltungsanalyse Schaltungsoptimierung | Epic, Grenoble |
| XELGA | Wellenformanzeige und Wellenform-Postprozessor (z.B. Fourier-Analyse) | Mentor Graphics |
| VERILOG | Digitale Schaltungssimulation | Cadence |

Alle Programme besitzen sogenannte Online-Manuals und werden weltweit vertrieben und benutzt.

Verfahren der hier beschriebenen Art zur Analyse und Optimierung von integrierten Schaltungen können einerseits eingesetzt werden, um integrierte Schaltungen, die zunächst nur in einer virtuellen Welt in Form von Schaltbildern und/oder Layout-Zeichnungen und in Form von Computermodellen vorliegen, zu bewerten und zu optimieren, bevor sie in eine reale Welt umgesetzt werden, nämlich in Halbleiterchips. Da die Umsetzung in wirkliche Halbleiterchips sehr zeit- und kostenaufwendig ist, werden solche Bewertungs- und Optimierungsvorgänge in der virtuellen Welt stark bevorzugt und zunehmend eingesetzt. Dabei ist erwünscht und angestrebt, eine weitestgehende Automatisierung zu erreichen, derart, daß Analyse- und/oder Optimierungsverfahren gemäß vorliegender Erfindung in einen automatisierten Programmablauf eingebaut werden, der sowohl auf der Anfangsseite als auch auf der Endseite automatisierte Schnittstellen zur physikalischen Welt enthält, derart, daß beispielsweise Meßergebnisse auf der Eingangsseite und Herstellungssteuereinrichtungen, beispielsweise Maskenherstellungs- oder Layouttrimmeinrichtungen, auf der Ausgangsseite, über eine eingangsseitige bzw. ausgangsseitige automatisierte Schnittstelle mit dem erfindungsgemäßen Analyse- und/oder Optimierungsverfahren verknüpft werden. Von der Meßeinrichtung bis zur Maskenherstellungs- oder Layouttrimmeinrichtung kann dann eine durchgängige Programmsteuerung erfolgen, welche keinerlei Eingreifen oder Einflußnahme durch Menschen mehr bedarf.

Nachfolgend werden einige praktische Möglichkeiten derartiger vollautomatisierter Abläufe betrachtet.

Falls bereits eine integrierte Schaltung (nachfolgend in üblicher Weise mit IC abgekürzt) bereits existiert, kann man unter Zuhilfenahme des erfindungsgemäßen Verfahrens eine Analyse und/oder Optimierung des IC vornehmen, was vollständig automatisiert geschehen kann. Beispielsweise erfolgt eine Analyse und/oder Optimierung im Hinblick auf elektromagnetische Störstrahlungen des IC, wie sie sich an einzelnen Anschlußstiften oder Pins des IC auswirken.

Zunächst erfolgt eine pin-selektive Messung der elektromagnetischen Abstrahlung des Prüflings-IC. Für diese wird vorzugsweise ein Meßverfahren gemäß dem Normierungsvorschlag VDE AK 767.13/14.5, veröffentlicht in "Messung der EME von integrierten Schaltungen", erschienen bei ZVEI Fachverband Bauelemente der Elektronik, Königstorgraben 11, 90402 Nürnberg, Version 1.1, Mai 1995, verwendet. Zur pin-selektiven Messung kann ein Roboter verwendet werden, der automatisiert eine Pin-zu-Pin-Umschaltung bewirkt, wodurch der Reihe nach alle oder ausgewählte Pins hinsichtlich ihrer Störabstrahlung gemessen werden. Aufgrund dieser Messungen wird beispielsweise der Pin mit der höchsten Störabstrahlung ermittelt. Anhand einer Datenbank, in welcher gespeichert ist, welche Pins des IC mit welchen Zellen des IC verbunden sind, wird ermittelt, welche Zelle bzw. welche Zellen zu dem aufgrund der gemessenen Störabstrahlung ausgewählten Pin gehört bzw. gehören. Für eine derart ermittelte Zelle des IC wird dann das erfindungsgemäße Verfahren durchgeführt. Zu diesem Zweck kann entweder nach Ermittlung der Zelle anhand eines Layout- oder Schaltbild-Analyseprogramms das Fein-Grob-Computermodell für die ausgewählte Zelle des IC erstellt und das erfindungsgemäße Analyseverfahren durchgeführt werden. Eine andere Möglichkeit ist die, auf eine Datenbank zurückzugreifen, in welcher für die einzelnen Zellen des IC bereits Fein-Grob-Computermodelle der erfindungsgemäßen Art gespeichert sind, und dasjenige Fein-Grob-Computermodell aus dieser Datenbank abzurufen, das zu der aufgrund der pin-selektiven Messung der Störabstrahlung ermittelten Zelle gehört. Dieses Verfahren kann entweder bis zu einem Analyseergebnis des in Anspruch 1 angegebenen Verfahrens oder bis zu einer Optimierung mit dem in Anspruch 3 angegebenen Verfahren durchgeführt werden. Das softwaremäßige Analyse- oder Optimierungsergebnis kann dann dazu verwendet werden, um ein programmgesteuertes IC-Herstellungsverfahren, insbesondere Maskenherstellungsverfahren oder Leiterbahnentrimmverfahren, mit den bei der vorausgehenden Analyse oder Optimierung erhaltenen Parametern zu steuern.

Der ganze Vorgang von der pin-selektiven Messung bis zur Maskenherstellung für ein modifiziertes IC oder für ein Leiterbahntrimmen des existierenden IC während des Herstellungsprozesses kann vollautomatisiert, das heißt, ohne jeglichen Eingriff durch Menschen, ablaufen. Zu diesem Zweck können einzelne Programmteile, wie das die pin-selektive Messung und die Roboterfunktion steuernde Programm, das erfindungsgemäße Analyse- oder Optimierungsprogramm und das die Maskenherstellung oder Leiterbahntrimmung steuernde Programm, über gegenseitige Programmschnittstellen zu einem Gesamtprogramm zusammengefaßt werden. Es ist dann allenfalls noch erforderlich, die einzelnen Programme der bereits existierenden Art mit geeigneten Schnittstellen und/oder Programmfiltern zu versehen, damit die einzelnen Programme in Zusammenfügung vollautomatisiert den gesamten Ablauf von der pin-selektiven Messung bis zur Maskenerstellung oder Leiterbahntrimmung abwickeln können.

Eine andere Möglichkeit ist die Verwendung eines erfindungsgemäßen Verfahrens für eine bewertete Stromaufnahme eines erst virtuell oder schon tatsächlich integrierten IC. Dabei wird zunächst wieder das Layout- oder Schaltbild der integrierten Schaltung mittels eines Layout- oder Schaltbild-Analyseprogramms zur Erstellung eines Computermodells eingelesen. Danach wird eine Grobsimulation nach Art des in Anspruch 2 angegebenen Verfahrens durchgeführt. Anhand des bezüglich Stromaufnahme bewerteten Grobsimulationsergebnisses wird eine Zelle des IC ausgewählt. Die Strombewertung erfolgt dabei vorzugsweise nach der Art des zeitlichen Stromwertwechsels. Zellen, die eine Stromaufnahme in Form nur oder im wesentlichen nur eines konstanten Gleichstroms haben, somit keine oder praktisch keine Störabstrahlung verursachen, können außer Betracht bleiben, wenn es wieder um die Analyse oder Optimierung von Zellen hinsichtlich ihres Störabstrahlverhaltens geht. Zellen dagegen, die eine Stromaufnahme mit hohen und/oder häufigen Stromstärkewechseln aufweisen, somit besonders zur Störabstrahlung beitragen, werden für eine Analyse oder Optimierung ausgewählt. Für die so ausgewählte Zelle wird dann das erfindungsgemäße Simulationsverfahren mit Fein-Grob-Computermodell durchgeführt, an dessen Ende die hinsichtlich Störabstrahlung analysierten oder optimierten Parameter der Zelle feststehen.

Am Anfang dieses Verfahrens zur bewerteten Stromaufnahme steht entweder die Grobsimulation (insbesondere wenn nur eine virtuelles IC vorliegt) oder eine Messung der Stromaufnahme, wenn bereits ein tatsächlich existierendes IC vorliegt. Mit dem am Ende des Verfahrens vorliegenden Analyse- oder Optimierungsergebnis können durch das Programm wieder physikalische Größen gesteuert werden, beispielsweise bei der Maskenherstellung für das herzustellende tatsächliche IC oder für eine Leiterbahntrimmung eines bereits existierenden IC.

Auch hier kann wieder eine volle Automatisierung vom Einlesen des IC-Schaltbildes bzw. von der Durchführung der Stromaufnahmemessungen bis zur Maskenherstellung bzw. Leiterbahntrimmung durchgeführt werden, indem die einzelnen Programmteile über geeignete Schnittstellen zu einem funktionsmäßig durchgängigen Gesamtprogramm zusammengefügt werden.

Während sich die vorausgehenden Beispiele hauptsächlich mit der Vorbereitung der elektrischen Analyse bzw. Auswahl der zu verbessernden Zelle eines IC befaßten, seien nachfolgend die Möglichkeiten der Auswertung der elektrischen Analyse oder Optimierung noch näher betrachtet.

Eine Anwendungsmöglichkeit ist eine automatische Layoutmodifikation eines IC-Layouts als Basis zur Maskenherstellung einer Zelle eines IC bzw. des gesamten IC. Nach dem Umsetzen des bereits existierenden Layout- oder Schaltbildplans des herzustellenden IC wird das Fein-Grob-Computermodell erzeugt oder alternativ aus einer Datenbank, in welcher für einzelne Zellen des herzustellenden IC bereits Fein-Grob-Computermodelle gespeichert sind, abgerufen. Anhand dieses Fein-Grob-Computermodells wird dann eine Optimierung mit dem erfindungsgemäßen Iterationsverfahren durchgeführt. Das Optimierungsergebnis wird in ein an sich bekanntes Netzlistenprogramm eingespeist, mit dessen Hilfe eine Netzliste der optimierten Zelle hergestellt wird, die zur automatischen Generierung eines optimierten Layouts der Zelle bzw. des gesamten IC führt. Hierzu kann beispielsweise das Programm LAS der Firma Cadence oder ein entsprechendes Programm einer anderen Softwarefirma verwendet werden.

Eine andere Möglichkeit ist die, für dieselbe gewünschte Funktion verschiedene Lösungen zu vergleichen und unter bestimmten Gesichtspunkten, beispielsweise der Minimierung der Störabstrahlung, die bestmögliche Lösung programmgesteuert auswählen zu lassen. Zu diesem Zweck können verschiedene Zellen, die für die gleiche Aufgabe bestimmt sind, hinsichtlich des interessierenden Verhaltens, beispielsweise Störabstrahlverhaltens, analysiert und miteinander verglichen werden. Die Zelle mit dem besten Verhalten kann dann ausgewählt und für das herzustellende IC verwendet werden. Dieses Verfahren kann für nur eine Zelle des ICs durchgeführt werden oder auch für mehrere verschiedene Zellen des IC. Nach Beendigung dieses Zellenauswahlverfahrens wird dann unter Berücksichtigung der ausgewählten Zelle bzw. Zellen ein Maskenlayout erstellt, was automatisch mit dem Gesamtprogramm geschehen kann. Das heißt, von der softwaremäßigen Erfassung der für die Auswahl zu vergleichenden Zellen bis zur Maskenherstellung kann ein durchgängig automatischer Verfahrensprozeß ablaufen, ohne daß irgendein menschlicher Eingriff erforderlich wäre.

Eine andere Anwendungsmöglichkeit der erfindungsgemäßen Methode ist die Ermittlung der optimalen Stützkapazität von auf dem IC mitintegrierten Stützkondensatoren und deren Trimmabgleich auf die als optimal ermittelte Stützkapazität.

Es ist üblich, integrierte Schaltungen mit integrierten Stützkapazitäten zu versehen, welche die Funktion eines Strompuffers oder einer kleinen Pufferbatterie haben. Diese Stützkapazitäten wirken zwischen den beiden Spannungsversorgungsleitungen ($V_{DD}$ und Vss). Problematisch sind sie, da sie mit Induktivitäten, insbesondere von Leiterbahnen des IC, zu Serienresonanzen führen, entsprechend der bekannten Formel

$$fr \approx \frac{1}{2\pi\sqrt{LC}}$$

Dabei bedeuten fr die Serienresonanzfrequenz, L die Leiterbahneninduktivität und C die Stützkapazität. Bei der Resonanzfrequenz entsteht praktisch ein Kurzschluß zwischen den beiden Spannungsversorgungspolen. Dieser Effekt ist besonders unerwünscht, wenn er beispielsweise im Frequenzbereich von UKW- oder FM-Radiosendern, zum Beispiel im Bereich von 96 MHz, auftritt.

Ein derartiger Effekt kann auch bei integrierten Schaltungen auftreten, die nicht mit Stützkapazitäten versehen sind. Die Leiterbahnen von integrierten Schaltungen bilden bekanntlich Kapazitäten. Solche Leiterbahnenkapazitäten können zusammen mit Leiterbahneninduktivitäten ebenfalls zu Resonanzeffekten führen, die sich störend auswirken können.

Liegen solche Resonanzen in störenden Frequenzbereichen, kann man in bekannter Weise solche Resonanzen in unkritische Frequenzbereiche dadurch verlagern, daß man mittels Laserstrahlen oder Ionenstrahlen die betroffen Leiterbahnen trimmt, also Teile solcher Leiterbahnen abträgt. Bei einem bereits existierenden IC ist ein solches Trimmen natürlich nur in einer Richtung möglich, weil die Leiterbahnen bzw. Elektroden von Stützkapazitäten durch solches Trimmen nur verkleinert werden können.

Unter Einsatz des erfindungsgemäßen Verfahrens kann man ein solches Trimmen bereits anhand des Grob-Fein-Computermodells durchführen, was ein "vituelles Trimmen" in beiden Richtungen erlaubt, nämlich in Richtung Verkleinerung als auch in Richtung Vergrößerung der zu trimmenden Leiterbahnen oder Kondensatorelektroden. Zu diesem Zweck kann mit dem erfindungsgemäßen Verfahren eine die betroffene Leiterbahn oder Kondensatorelektrode enthaltende Zelle des IC analysiert und in einem softwaremäßigen "Trimmvorgang" so optimiert werden, daß die genannten Frequenzen in einem unkritischen Frequenzbereich zu liegen kommen. Das Optimierungsergebnis kann dann in das Steuerprogamm zur Steuerung des Laser- oder Ionenstrahl-Trimmgerätes eingegeben werden, um eine auf einem real existierenden IC bereits vorhandene Kondensatorelektrode oder Leiterbahn entsprechend dem Optimierungsergebnis zu trimmen.

Hierzu eignet sich beispielsweise ein Gerät mit der Bezeichnung Micrion 9000 der Firma Micrion in München. Dieses Gerät kann automatisch ICs ansteuern, und zwar programmierbar über seinen Steuerrechner. Über Schnittstellen oder Filter kann eine automatisierte Programmumsetzung vorgenommen werden, mittels welcher das mit dem erfindungsgemäßen Verfahren erzielte Bewertungs- oder Optimierungsergebnis in das Steuerprogramm von Micrion 9000 eingespeist werden kann.

Wie bereits angesprochen, ist es besonders vorteilhaft, den Trimmvorgang softwaremäßig bereits durchzuführen, bevor überhaupt zu trimmende Leiterbahnen oder Kondensatorelektroden hergestellt werden. Ein solches Trimmen findet vorab softwaremäßig statt und es werden mit diesem Trimmergebnis bereits die Layout- und Leiterbahnenmasken gesteuert, vorzugsweise vollautomatisch, so daß die Erzeugung solcher Leiterbahnen und Kondensatorelektroden bereits mit dem optimierten Layout geschieht.

**Patentansprüche**

1. Verfahren zur Analyse des elektrischen Verhaltens mindestens einer bestimmten Zelle einer monolithisch integrierten Schaltung, mit folgenden in einem automatisierten durchgangigen Programmablauf durchgeführten Schritten:

   a) mittels eines bekannten Layout- oder Schaltbild-Analyseprogramms wird von der gesamten integrierten Schaltung (IC) anhand von deren Layout bzw. Schaltbild ein Fein-Grob-Computermodell erzeugt, indem erstellt werden:

a1) ein aktive und passive Bauelemente und parasitäre Komponenten berücksichtigendes Feinmodell von der interessierenden Zelle (Z)

a2) und ein nur passive Bauelemente in Form von komplexen Widerständen berücksichtigendes Grobmodell von mindestens dem Rest der integrierten Schaltung (IC);

b) anhand des Fein-Grob-Computermodells wird eine Feinsimulation durchgeführt, indem vorbestimmte Betriebsparameter, wie insbesondere die Betriebstemperatur und die Versorgungsspannung, vorgegeben werden, mindestens ein Eingang des Feinmodells der Zelle (Z) mit mindestens einem Stimulationssignal beaufschlagt wird und dabei an Ausgangsanschlüssen der Zelle und/oder der integrierten Schaltung des Fein-Grob-Computermodells entstehende Signalverläufe abgetastet und aufgezeichnet werden;

c) für jeden interessierenden Schaltungsknoten wird mittels einer Spektralanalysemethode ein Frequenzspektrum des zugehörigen aufgezeichneten Signalverlaufs erstellt;

d) das Frequenzspektrum wird durch Vergleich mittels einer gespeicherten Frequenzspektrumbewertungsschablone bewertet.

2. Verfahren nach Anspruch 1, bei welchem vor Schritt a) folgende zusätzliche Schritte durchgeführt werden:

e) mittels des bekannten Layout- oder Schaltbild-Analyseprogramms wird von der gesamten integrierten Schaltung (IC) anhand von deren Layout bzw. Schaltbild ein nur deren aktive Bauelemente berücksichtigendes Grobsimulationscomputermodell erzeugt;

f) es wird eine Grobsimulation durchgeführt, indem die vorbestimmten Betriebsparameter vorgegeben und Eingangsanschlüsse des Grobsimulationscomputermodells mit Testsignalen vorbestimmter Signalform beaufschlagt und dabei an Ein-und/oder Ausgangsanschlüssen der interessierenden Zelle (Z) des Grobsimulationscomputermodells entstehende analoge Antwortsignale als Stimulationssignale aufgezeichnet und gespeichert werden;

und bei welchem bei der Feinsimulation gemäß Schritt b) die in Schritt f) aufgezeichneten Stimulationssignale verwendet werden.

3. Verfahren nach Anspruch 1 oder 2, zur Verbesserung des elektromagnetischen Emissionsverhaltens der Zelle (Z) der integrierten Schaltung, wobei mittels einer programmgesteuerten Iterationsroutine und unter Beachtung vorbestimmter Funktionsgrenzen der Zelle

g) Schaltungsparameter des Feinmodells der Zelle (Z) gezielt geändert werden;

h) anhand des sich daraus ergebenden geänderten Fein-Grob-Computermodells die Schritte b) bis d) wiederholt werden;

i) das mit dem geänderten Fein-Grob-Computermodell jeweils erhaltene Bewertungsergebnis mit dem Bewertungsergebnis verglichen wird, das mit dem vorausgehenden Fein-Grob-Computermodell erhalten worden war;

j) anhand des Vergleichsergebnisses ermittelt wird, ob die vorausgehende Änderung von Schaltungsparametern des Feinmodells zu einer Verbesserung oder Verschlechterung des elektromagnetischen Emissionsverhaltens der Zelle geführt hat;

k) die Iterationsroutine mit erneuter Änderung der Schaltungsparameter des Feinmodells der Zelle fortgeführt wird, wobei die Schaltungsparameteränderung in Abhängigkeit von dem vorausgehenden Ermittlungsergebnis in gleicher oder entgegengesetzter Richtung wie bei der vorausgehenden Schaltungsparameteränderung vorgenommen wird, bis der Betrag der durch die jeweilige Schaltungsparameteränderung erzielten Änderung des elektromagnetischen Emissionsverhaltens unter einem vorbestimmten Schwellenwert zu liegen kommt.

4. Verfahren nach einem der Ansprüche 1 bis 3,
bei welchem für die Erstellung des Grobmodells neben dem Modell des Restes der integrierten Schaltung ($Z_R$) berücksichtigt werden:

ein Zuleitungsmodell ($Z_L$) und/oder
ein Spannungsversorgungsmodell ($V_{DD}$, $V_{SS}$) und/oder
ein Eingangsl AuSgangsStrukturmodell ($I/O_{IC}$) und/oder
ein Gehäusesdukmrmodell ($M_P$) und/oder
ein Lastmodell (LAST).

5. Verfahren nach einem der Ansprüche 1 bis 4,

bei welchem bei den Schritten a) und e) mittels eines Schaltungslayoutprogramms eine Netzlistenbeschreibung des Fein-Grob-Computermodells bzw. des Grobsimulationscomputermodells erstellt wird, welche passive und parasitäre Elemente in Form von Widerständen (R), Kapazitäten (C) und Induktivitäten (L) und aktive Elemente in Form von Transistoren und Dioden berücksichtigt.

6. Verfahren nach einem der Ansprüche 1 bis 5,
bei welchem die Grobsimulation gemäß Schritt e) mit Testsignalen durchgeführt wird, die zu einer möglichst periodischen Arbeitsweise des Grobsimulationscomputermodells führen.

7. Verfahren nach einem der Ansprüche 1 bis 6,
bei welchem bei den Schritten b) und f) Betriebsparameter für typischen Betrieb vorgegeben werden.

8. Verfahren nach einem der Ansprüche 1 bis 7,
bei welchem bei den Schritten b) und f) Betriebsparameter für schlechteste Betriebsbedingungen vorgegeben werden.

9. Verfahren nach einem der Ansprüche 1 bis 8,
bei welchem im Rahmen von Schritt b) ein an mindestens einem Ausgangsschaltungsknoten der integrierten Schaltung entstehender Signalverlauf aufgezeichnet wird.

10. Verfahren nach einem der Ansprüche 1 bis 9,
bei welchem die Abtastung im Rahmen von Schritt b) mit einer Abtastfrequenz durchgeführt wird, die mindestens so hoch ist wie die vom Abtasttheorem geforderte Abtastfrequenz.

11. Verfahren nach Anspruch 10,
bei welchem die Abtastung mit einer Abtastfrequenz durchgeführt wird, die mindestens fünf mal so hoch ist wie die vom Abtasttheorem geforderte Abtastfrequenz.

12. Verfahren nach einem der Ansprüche 1 bis 11,
bei welchem bei Schritt c) die zu analysierenden Signalverläufe einer Fouriertransformation unterzogen werden.

13. Verfahren nach einem der Ansprüche 1 bis 11,
bei welchem bei Schritt c) die zu analysierenden Signalverläufe einer Z-Transformation unterzogen werden.

14. Verfahren nach einem der Ansprüche 1 bis 13,
bei welchem im Rahmen der Feinmodellerstellung bei Schritt a) zunächst mittels eines herkömmlichen programmgesteuerten Extraktionsverfahrens die zwischen je zwei Schaltungsknoten vorhandenen parasitären Elemente je in Form einer komplexen Impedanz extrahiert und diese danach mittels eines Computerprogramms in ein Ersatznetzwerk mit verteilten Impedanzelementen umgewandelt wird.

**Claims**

1. A method for an analysis of an electrical behaviour at least of a specific cell of a monolithically integrated circuit, comprising the following steps which are carried out in an automated, continuous program flow:

a) providing a fine-coarse computer model of the whole integrated circuit (IC) using its layout and circuit diagram, respectively, by means of a known layout or circuit diagram analysis program, wherein it is provided:

a1) a fine model of the cell (Z) of interest, which takes into account active and passive components and parasitic components, and
a2) a coarse model of at least the remainder of the integrated circuit (IC), which takes into account only passive components in form of complex resistances;

b) wherein using the fine-coarse computer model a fine simulation is performed using predetermined operating parameters, particularly like the operation temperature and the supply voltage, which are preset, wherein at least an input of the fine model of the cell (Z) is supplied with at least a stimulation signal, wherein thereby at output terminals of the cell and/or of the integrated circuit of the fine-coarse computer model emerging signal patterns are scanned and recorded;

c) for each circuit node of interest, a frequency spectrum of the associated signal pattern recorded is produced by means of a spectrum analysis method;

d) the frequency spectrum is assessed by comparison by means of a frequency spectrum assessment master pattern stored.

2. Method according to claim 1, wherein before performing step a), the following additional steps are carried out:

e) by means of the known layout or circuit diagram analysis program a coarse simulation computer model of the whole integrated circuit is generated which takes into account only its active components by means of its layout and circuit diagram, respectively;

f) a coarse simulation is carried out in a manner that the predetermined operation parameters are preset and input terminals of the coarse simulation computer model are supplied with test signals having predetermined signal form, wherein analog response signals which are provided thereby at input and/or output terminals of the cell (Z) of interest of the coarse simulation computer model are recorded and stored as stimulating signals;

and wherein the stimulating signals recorded in step f) are used with the fine simulation according to step b).

3. Method according to claim 1 or 2, for improving an electromagnetic emission behaviour of the cell (Z) of the integrated circuit, in which by means of a program-controlled iteration routine and in consideration of predetermined functional limits of the cell

g) circuit parameters of the fine model of the cell (Z) are changed purposefully;

h) steps b) to d) are repeated by way of an amended fine-coarse computer model arising therefrom;

i) the respective assessment result obtained by the amended fine-coarse computer model is compared with an assessment result that was obtained by a preceding fine-coarse computer model;

j) it is ascertained by way of the comparison result whether the preceding change of circuit parameters of the fine model has led to an improvement or a deterioration of the electromagnetic emission behaviour of the cell; and

k) the iteration routine is continued with a renewed alteration of the circuit parameters of the fine model of the cell, with the circuit parameter alteration being carried out in accordance with the preceding assessment result in the same or opposite direction as in the preceding circuit parameter alteration, until the amount of the alteration of the electromagnetic emission behaviour obtained by the respective circuit parameter alteration comes to lie below a predetermined threshold value.

4. Method according to one of claims 1 to 3, wherein any of the following is taken into consideration for making the coarse model in addition to the model of the remainder of the integrated circuit ($Z_R$):

a supply line model ($Z_L$) and/or
a voltage supply model ($V_{DD}$, $V_{SS}$) and/or
an input/output structure model ($I/O_{IC}$) and/or
a package structure model ($M_P$) and/or
a load model (LAST).

5. Method according to any of claims 1 to 4, wherein at the steps a) and e) by means of a circuit layout program a network list description of the fine-coarse computer model and the coarse simulation computer model, respectively, is obtained, which takes into account passive and parasitic elements in the form of resistors (R), capacitors (C) and inductances (L) and active elements in the form of transistors and diodes.

6. Method according to any of claims 1 to 5, wherein the coarse simulation according to step e) is performed with test signals which result in a preferably periodic operation of the coarse simulation computer model.

7. Method according to any of claims 1 to 6, wherein at the steps b) and f) operation parameters for a typical operation are preset.

8. Method according to any of claims 1 to 7, wherein at the steps b) and f) operation parameters for worst operation conditions are preset.

9. Method according to any of claims 1 to 8, wherein, in the scope of step b), a signal pattern is recorded that arises on at least one output circuit node of the integrated circuit.

10. Method according to any of claims 1 to 9, wherein scanning in the scope of step b) is performed with a scanning frequency that is at least as high as a scanning frequency demanded by the scanning theorem.

11. Method according to claim 10, wherein the scanning is carried out with a scanning frequency that is at least five times as high as the scanning frequency demanded by the scanning theorem.

12. Method according to any of claims 1 to 11, wherein the signal patterns to be analysed are subjected to a Fourier transformation at step c).

13. Method according to any of claims 1 to 11, wherein the signal patterns to be analysed are subjected to a Z-transformation at step c).

14. Method according to any of claims 1 to 13, wherein, in the scope of the preparation of the fine model at step a), the parasitic components present between two circuit nodes each are at first extracted in the form of a complex impedance by means of a conventional program-controlled extraction method and said impedance then is converted by means of a computer program into an equivalent network with distributed impedance elements.

**Revendications**

1. Procédé pour l'analyse du comportement électrique d'au moins une cellule déterminée d'un circuit à intégration monolithique, comprenant les étapes suivantes mises en oeuvre dans un déroulement de programme général automatisé, dans lesquelles :

   a) au moyen d'un programme d'analyse connu du tracé ou du schéma de connexions, on génère un modèle informatique fin-grossier du circuit intégré total (IC) sur base du tracé respectivement du schéma de connexion de ce dernier, en élaborant :

   a1) un modèle fin de la cellule d'intérêt (Z) prenant en compte les composants actifs et passifs et les composants parasitaires
   a2) et un modèle grossier d'au moins le reste du circuit intégré (IC), prenant en compte uniquement les composants passifs sous la forme de résistances complexes ;

   b) sur base du modèle informatique fin-grossier, on procède à une simulation fine en fixant au préalable des paramètres de fonctionnement prédéfinis, en particulier la température de fonctionnement et la tension d'alimentation, on sollicite au moins une entrée du modèle fin de la cellule (Z) avec au moins un signal de stimulation et, en l'occurrence, on balaie et on enregistre les allures de signaux que l'on obtient aux bornes de sortie de la cellule et/ou du circuit intégré du modèle informatique fin-grossier ;
   c) pour chaque noeud de circuit d'intérêt, on établit, au moyen d'un procédé d'analyse spectrale, un spectre de fréquence de l'allure de signal correspondante qui a été enregistrée ;
   d) on évalue le spectre de fréquence par comparaison au moyen d'un gabarit d'évaluation de spectre de fréquence mémorisé.

2. Procédé selon la revendication 1, dans lequel, avant l'étape a), on franchit les étapes supplémentaires suivantes dans lesquelles :

   e) au moyen du programme d'analyse connu du tracé ou du schéma de connexions, on génère un modèle informatique de simulation grossière du circuit intégré total (IC), sur base du tracé, respectivement du schéma des connexions, ledit modèle ne prenant en compte que les composants actifs du circuit ;
   f) on procède à une simulation grossière en fixant au préalable les paramètres de fonctionnement prédéfinis et en sollicitant les bornes d'entrée du modèle informatique de simulation grossière avec des signaux test possédant une forme de signal prédéfinie, et en l'occurrence on enregistre et on mémorise sous la forme de signaux de stimulation, des signaux de réponse analogiques qui apparaissent aux bornes d'entrée et/ou de sortie de la cellule d'intérêt (Z) du modèle informatique de simulation grossière ;

   et procédé dans lequel, au cours de la simulation fine conformément à l'étape b), on utilise les signaux de stimulation enregistrés à l'étape f).

**3.** Procédé selon la revendication 1 ou 2, pour l'amélioration du comportement d'émission électromagnétique de la cellule (Z) du circuit intégré, dans lequel, au moyen d'une routine d'itération commandée par un programme et en prenant en compte les limites fonctionnelles prédéfinies de la cellule,

g) on modifie de manière ciblée les paramètres de circuit du modèle fin de la cellule (Z) ;
h) sur base du modèle informatique fin-grossier modifié que l'on obtient de la sorte, on répète les étapes b) à d) ;
i) on compare le résultat d'évaluation que l'on obtient respectivement avec le modèle informatique fin-grossier modifié au résultat d'évaluation que l'on avait obtenu avec le modèle informatique fin-grossier précédent ;
j) sur base du résultat de la comparaison, on détermine le fait de savoir si la modification précédente des paramètres de circuit du modèle fin a donné lieu à une amélioration ou à une détérioration du comportement d'émission électromagnétique de la cellule ;
k) on poursuit la routine d'itération avec une nouvelle modification des paramètres de circuit du modèle fin, la modification des paramètres du circuit étant mise en oeuvre en fonction du résultat de détermination précédent dans la même direction ou dans la direction opposée à celle de la modification des paramètres de circuit précédente, jusqu'à ce que la valeur de la modification du comportement d'émission électromagnétique, que l'on obtient via la modification respective des paramètres de circuit, soit inférieure à une valeur seuil prédéfinie.

**4.** Procédé selon l'une quelconque des revendications 1 à 3, dans lequel, pour l'établissement du modèle grossier, à côté du modèle du reste du circuit intégré ($Z_R$)' on prend en compte :

un modèle d'amenée ($Z_L$) et/ou
un modèle d'alimentation de tension ($V_{DD}$, $V_{SS}$) et/ou un modèle de structure d'entrée/sortie ($I/O_{IC}$) et/ou un modèle de structure de boîtier ($M_P$) et/ou un modèle de charge (LAST).

**5.** Procédé selon l'une quelconque des revendications 1 à 4, dans lequel, aux étapes a) et e), au moyen d'un programme de tracé du circuit, on établit une description de liste de réseaux du modèle informatique fin-grossier, respectivement du modèle informatique de simulation grossière, qui prend en compte les éléments passifs et parasitaires sous la forme des résistances (R), des capacitances (C) et des inductances (L) et les éléments actifs sous la forme des transistors et des diodes.

**6.** Procédé selon l'une quelconque des revendications 1 à 5, dans lequel on procède à la simulation grossière conformément à l'étape e) avec des signaux test qui permettent d'envisager une méthode de travail la plus périodique possible du modèle informatique de simulation grossière.

**7.** Procédé selon l'une quelconque des revendications 1 à 6, dans lequel, aux étapes b) et f), on fixe au préalable des paramètres de fonctionnement pour un fonctionnement typique.

**8.** Procédé selon l'une quelconque des revendications 1 à 7, dans lequel, aux étapes b) et f), on fixe au préalable des paramètres de fonctionnement pour les pires conditions de fonctionnement.

**9.** Procédé selon l'une quelconque des revendications 1 à 8, dans lequel, dans le cadre de l'étape b), on enregistre une allure de signal que l'on obtient à au moins un noeud du circuit de sortie du circuit intégré.

**10.** Procédé selon l'une quelconque des revendications 1 à 9, dans lequel, le balayage dans le cadre de l'étape b) est mis en oeuvre avec une fréquence de balayage qui est au moins aussi élevée que la fréquence de balayage exigée par le théorème de balayage.

**11.** Procédé selon la revendication 10, dans lequel on effectue le balayage avec une fréquence de balayage qui est au moins cinq fois plus élevée que la fréquence de balayage exigée par le théorème de balayage.

**12.** Procédé selon l'une quelconque des revendications 1 à 11, dans lequel, dans le cadre de l'étape c), on soumet les allures de signaux à analyser à une transformation de Fourier.

**13.** Procédé selon l'une quelconque des revendications 1 à 11, dans lequel, dans le cadre de l'étape c), on soumet les allures de signaux à analyser à une transformation Z.

**14.** Procédé selon l'une quelconque des revendications 1 à 13, dans lequel, dans le cadre de l'élaboration du modèle fin à l'étape a), on extrait d'abord, au moyen d'un procédé d'extraction habituel commandé par un programme, les éléments parasitaires présents entre respectivement deux noeuds de circuit, respectivement sous la forme d'une impédance complexe, et on transforme ensuite cette dernière au moyen d'un programme informatique en un réseau équivalent comprenant des éléments d'impédance répartis.

FIG.1

EP 0 855 662 B1

INVERTER    V<sub>DD</sub>

M1

A ○———————○ B    SCHALTBILD

M2

V<sub>SS</sub>    IDEAL

FIG.2

M1

S    V<sub>DD</sub>

A    LAYOUT

D    B

FIG.3    D

S    V<sub>SS</sub>

M2

V<sub>DD</sub>

R<sub>G1</sub>    R<sub>S1</sub>    EXTRAHIERTES
MODELL

M1

R<sub>A</sub>    R<sub>D1</sub>    R<sub>B</sub>

A ○———\/\/\———    ———\/\/\——○ B

R<sub>D2</sub>

R<sub>G2</sub>    M2    C

R<sub>S2</sub>

FIG.4    V<sub>SS</sub>    REAL

**dB** **V [ µv ]**

f1          f2

f3

HÜLLKURVE
GÜTEKLASSE A

f4                          f5

HÜLLKURVE
GÜTEKLASSE B

f [ FREQUENZ ]

FIG. 5

FIG.6

V(ICOUT)

FIG.7

V(NET137)

FIG.8

V(ICOUT)

FIG.9

V(NET 137)

dB  GdB(V(NET137))                                    FIG.11

VSS noise

dB  GdB(V(ICOUT))                                     FIG.10

pin spectrum

FIG.13

dB GdB(V(NET137))

VSS noise

FIG.12

dB GdB(V(ICOUT))

pin spectrum

**EP 0 855 662 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0481117 A1
- EP 0556900 A2

**In der Beschreibung aufgeführte Nicht-Patentliteratur**

- **P. BECQUE.** Getrennt spezifizieren, vereint simulieren. *Elektronik,* 06. Oktober 1995, vol. 44 (20), 102-108
- **T.J. Thatcher et al.** Automatic partitioning and dynamic mixed-mode simulation. *IEEE, 1992, Custom integrated circuits conference,* 03. Mai 1992, 12.7.1-12.7.4
- **R. BEALE et al.** Design methodology and simulation tools for mixed analog-digital integrated circuits. *IEEE International systems on circuits and systems,* Mai 1990, 1351-1355
- Messung der EME von integrierten Schaltungen. *ZVEI Fachverband Bauelemente der Elektronik,* Mai 1995

24